# EUROPEAN PATENT APPLICATION

(11) **EP 4 440 261 A1**
(43) Date of publication of application: **02.10.2024**
(21) Application number: 23218624.7
(22) Date of filing: 20.12.2023
(51) Int. Cl.: H05K 7/14, H05K 7/20

(54) **MOTOR CONTROLLER, AND ELECTRIC MOTOR AND VEHICLE COMPRISING SAME**

(30) Priority: 31.03.2023 CN 202310355990
(71) Applicant: XPT EDS (Hefei) Co., Ltd., Hefei City, Anhui 230601 (CN)
(72) Inventor: LI, Ming, Hefei City, Anhui, 230601 (CN); HUANG, Gang, Hefei City, Anhui, 230601 (CN); LIU, Chaohua, Hefei City, Anhui, 230601 (CN); WANG, Xinguo, Hefei City, Anhui, 230601 (CN)
(74) Representative: Vossius & Partner Patentanwälte Rechtsanwälte mbB

(57) **Abstract**

The disclosure relates to the technical field of controllers, and in particular to a motor controller, and an electric motor and a vehicle comprising the motor controller, in order to solve the problems of complex assembly, large size and heavy weight of conventional motor controllers. To this end, the motor controller of the disclosure comprises a water-cooling plate, and a direct-current port module, an alternating-current port module and an integrated circuit board that are electrically connected to each other, wherein the direct-current port module and the alternating-current port module are both mounted on the water-cooling plate, the integrated circuit board is mounted on the direct-current port module and/or the alternating-current port module, the direct-current port module and the alternating-current port module are each integrated into one component, and the integrated circuit board is a complete circuit board formed by integrating a control board and a drive board. With such an arrangement, assembling steps of the motor controller can be simplified greatly. In addition, by integrating a plurality of components into one component, the size and weight of the integrated component can be effectively reduced.

## Description

The present application claims priority of CN patent application 202310355990.X filed on March 31, 2023 with the title "Motor controller, and electric motor and vehicle comprising same".

### Technical Field

The disclosure relates to the technical field of controllers, and in particular to a motor controller, and an electric motor and a vehicle comprising the motor controller.

### Background Art

Current design forms of mainstream motor controllers have lasted for many years, and a complete industrial chain of each sub-component has been formed. Superficially, it is easy and cheap to purchase the components by means of the supply chain. However, due to lack of a deep understanding on the principles of an entire system and components thereof, it is very difficult to well achieve design breakthrough, and what we can only do is to simply assemble and connect separate components. Also, screw connection is an obsolete securing method. Although it is easy to purchase screwing devices, some screw locking problems have become bottlenecks in the industry and have not been solved.

The motor controllers of new energy vehicles available on the market are assembled by securing, with screws, a plurality of separate components and parts one by one in separate housings. This method has the defects of a large number of components and various types thereof, complex assembly, high risk of failure, large size and heavy weight, and is not in line with the development trend of new energy vehicles of a small size, light weight, high power density, high product quality and good stability.

Accordingly, there is a need for a new technical solution in the field to solve the problems described above.

### Summary

It aims to solve at least one of the above-mentioned problems in the prior art, that is, to solve the problems of complex assembly, large size and heavy weight of conventional motor controllers.

In a first aspect, the disclosure provides a motor controller. The motor controller comprises a water-cooling plate, and a direct-current port module, an alternating-current port module and an integrated circuit board that are electrically connected to each other, the direct-current port module and the alternating-current port module being both mounted on the water-cooling plate, the integrated circuit board being mounted on the direct-current port module and/or the alternating-current port module, the direct-current port module and the alternating-current port module being each integrated into one component, and the integrated circuit board being a complete circuit board formed by integrating a control board and a drive board.

According to the disclosure, assembling steps of the motor controller can be greatly simplified by integrating the direct-current port module into one component, integrating the alternating-current port module into one component, and further integrating the control board and the drive board into one complete integrated circuit board. In addition, by integrating a plurality of components into one component, the size and the weight of the integrated component can also be effectively reduced.

In a preferred technical solution of the above-mentioned motor controller, the direct-current port module comprises a first housing, and a large inverter capacitor, a filter capacitor, a magnetic filter core, a first input copper bar, a second input copper bar and a shielding plate that are integrated in the first housing, where the first housing is securely connected to the water-cooling plate, a first end of the first input copper bar and a first end of the second input copper bar both extend out of the first housing to be electrically connected to a positive electrode and a negative electrode of a battery pack respectively, and a second end of the first input copper bar and a second end of the second input copper bar respectively pass through a first penetration opening and a second penetration opening of the magnetic filter core and are electrically connected to the large inverter capacitor; and the large inverter capacitor is electrically connected to the alternating-current port module, the shielding plate is securely connected to the first housing and located on a side of the first housing away from the water-cooling plate, and the integrated circuit board is securely connected to the shielding plate.

In a preferred technical solution of the above-mentioned motor controller, the large inverter capacitor is provided with a power-taking terminal, and the power-taking terminal is electrically connected to the integrated circuit board.

Compared with a conventional design, in the disclosure, the power-taking terminal is directly integrated on the large inverter capacitor, and the power-taking terminal is welded to the integrated circuit board to provide a high-voltage power supply for the integrated circuit board, such that the structure is more simplified and the connecting stability is better.

In a preferred technical solution of the above-mentioned motor controller, the alternating-current port module comprises a second housing, and three alternating-current output copper bars and three current sensors that are integrated in the second housing, where one side of the second housing is securely connected to the water-cooling plate, the other side of the second housing is securely connected to the integrated circuit board, first ends of the alternating-current output copper bars extend out of the second housing to be electrically connected to the large inverter capacitor, and the three current sensors are respectively configured to detect the current of the corresponding alternating-current output copper bars.

In a preferred technical solution of the above-mentioned motor controller, the direct-current port module further comprises a first central point copper bar, a second central point copper bar, a transformer filter capacitor, a relay and a small relay capacitor for protecting the relay that are integrated in the first housing. The magnetic filter core is formed by integrating two magnetic cores, the magnetic filter core further comprises a third penetration opening, and the alternating-current port module further comprises a third central point copper bar integrated in the second housing; the first end of the second input copper bar is further used for electrical connection with a charging pile, a first end of the first central point copper bar extends out of the first housing to be electrically connected to the charging pile, and a second end of the first central point copper bar passes through the third penetration opening and is electrically connected to the relay; and a first end of the second central point copper bar is electrically connected to the relay, a second end of the second central point copper bar is electrically connected to a first end of the third central point copper bar, and a second end of the third central point copper bar extends out of the second housing to be electrically connected to a central point of an electric motor.

By integrating the two magnetic cores into one magnetic filter core, the space, weight and cost can be saved greatly. In addition, a conventional relay has a larger space occupied for mounting and supporting. According to the disclosure, the relay is integrated into the first housing without increasing the space, so that the limited space is fully utilized.

In a preferred technical solution of the above-mentioned motor controller, the second end of the first central point copper bar is provided with a first voltage sampling terminal, the first end of the second central point copper bar is provided with a second voltage sampling terminal, and the first voltage sampling terminal and the second voltage sampling terminal are both electrically connected to the integrated circuit board.

In a preferred technical solution of the above-mentioned motor controller, an end of the relay close to the water-cooling plate passes through the first housing to be securely connected to the water-cooling plate.

In a preferred technical solution of the above-mentioned motor controller, the first central point copper bar, the second input copper bar and the first input copper bar are arranged in sequence from an outer side to an inner side, and the first end of the first central point copper bar is provided close to the first end of the second input copper bar.

By arranging the first central point copper bar on the outermost side, the relay and the small relay capacitor are convenient to arrange. Moreover, after the voltage of the charging pile completely meets the requirements of the battery pack, that is, there is no need to increase the voltage for charging by means of a motor winding, such an arrangement also facilitates removing the first central point copper bar. Furthermore, by providing the first end of the first central point copper bar to be close to the first end of the second input copper bar, the first central point copper bar can share one external connector with the first input copper bar and the second input copper bar, thereby further optimizing a layout.

In a preferred technical solution of the above-mentioned motor controller, the third central point copper bar and the second central point copper bar are provided on the same side.

With such an arrangement, path shortening of the central point copper bars is facilitated, the cost is saved, and energy loss is also reduced.

In a second aspect, the disclosure further provides an electric motor, the electric motor comprising a motor controller in the above-mentioned technical solution.

In a third aspect, the disclosure further provides a vehicle, the vehicle comprising a motor controller in the above-mentioned technical solution.

In a preferred technical solution of the above-mentioned vehicle, the vehicle is an electric vehicle.

### Brief Description of the Drawings

A motor controller of the disclosure will be described below with reference to the accompanying drawings. In the drawings:
FIG. 1 is a first schematic perspective structural diagram of a motor controller of the disclosure;
FIG. 2 is a first top view of a motor controller of the disclosure (with an integrated circuit board not shown);
FIG. 3 is a second schematic perspective structural diagram of a motor controller of the disclosure (with an integrated circuit board and a shielding plate not shown);
FIG. 4 is a second top view of a motor controller of the disclosure (with an integrated circuit board and a shielding plate not shown);
FIG. 5 is a third top view of a motor controller of the disclosure (with an integrated circuit board, a shielding plate and a compressing cover not shown);
FIG. 6 is a first schematic perspective structural diagram of a direct-current port module of a motor controller of the disclosure (with a shielding plate not shown);
FIG. 7 is a second schematic perspective structural diagram of a direct-current port module of a motor controller of the disclosure (with a shielding plate, a first housing and a relay not shown);
FIG. 8 is a schematic perspective structural diagram of an alternating-current port module of a motor controller of the disclosure; and
FIG. 9 is a schematic perspective structural diagram of a power module of a motor controller of the disclosure.

### List of reference numerals

10 - Water-cooling plate;
20 - Direct-current port module; 201 - First housing; 202 - Large inverter capacitor; 203 - Filter capacitor; 204 - Magnetic filter core; 205 - First input copper bar; 206 - Second input copper bar; 207 - Shielding plate; 208 - First central point copper bar; 209 - Second central point copper bar; 210 - Transformer filter capacitor; 211 - Relay; 212 - Small relay capacitor;
2021 - Power-taking terminal; 2022 - First connection copper bar;
2041 - First penetration opening; 2042 - Second penetration opening; 2043 - Third penetration opening;
2081 - First voltage sampling terminal; 2091 - Second voltage sampling terminal;
30 - Alternating-current port module; 301 - Second housing; 302 - Alternating-current output copper bar; 303 - Current sensor; 304 - Third central point copper bar;
40 - Integrated circuit board;
50 - Power module; 501 - Second connection copper bar; 502 - Third connection copper bar;
60 - Compressing cover.

### Detailed Description of Embodiments

Preferred implementations of the disclosure are described below with reference to the accompanying drawings. Those skilled in the art should understand that these implementations are only used to explain the technical principles of the disclosure, and are not intended to limit the scope of protection of the disclosure. For example, although the following embodiments are described in conjunction with electric vehicles, the technical solution of the disclosure is also applicable to other types of vehicles, such as gasoline-electric hybrid vehicles, etc., and such corresponding application adjustments and changes, which do not depart from the principles of the disclosure, shall all fall within the scope of protection of the disclosure.

It should be noted that in the description of the disclosure, the terms such as "upper", "lower", "left", "right", "top" or "bottom" indicate directions or positional relationships shown in the drawings, which are only for convenience of description, rather than to indicate or imply that an apparatus or an element must have a specific orientation, or be constructed and operated in a specific orientation. Therefore, these terms cannot be interpreted as a limitation on the embodiments of the disclosure. In addition, the terms "first", "second", and "third" are for descriptive purposes only, and may not be interpreted as indicating or implying relative importance.

In addition, it should also be noted that in the description of the disclosure, the terms "mount", "provide", "connected to each other" and "connection" should be interpreted in a broad sense unless explicitly defined and limited otherwise. For example, a connection may be a secured connection, a detachable connection or an integral connection; may be a mechanical connection or an electrical connection; or may be a direct connection, an indirect connection by means of an intermediary, or internal communication between two elements. Those skilled in the art can understand specific meanings of the above terms in the disclosure according to specific situations.

Specifically, an electric vehicle of the disclosure comprises a battery pack and an electric motor, and the electric motor comprises a motor controller.

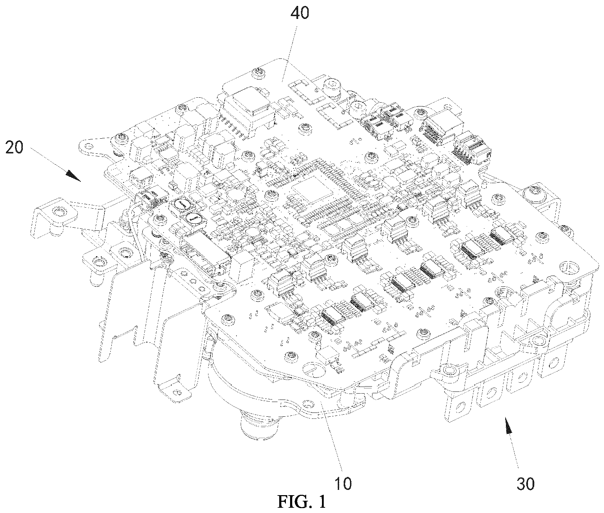

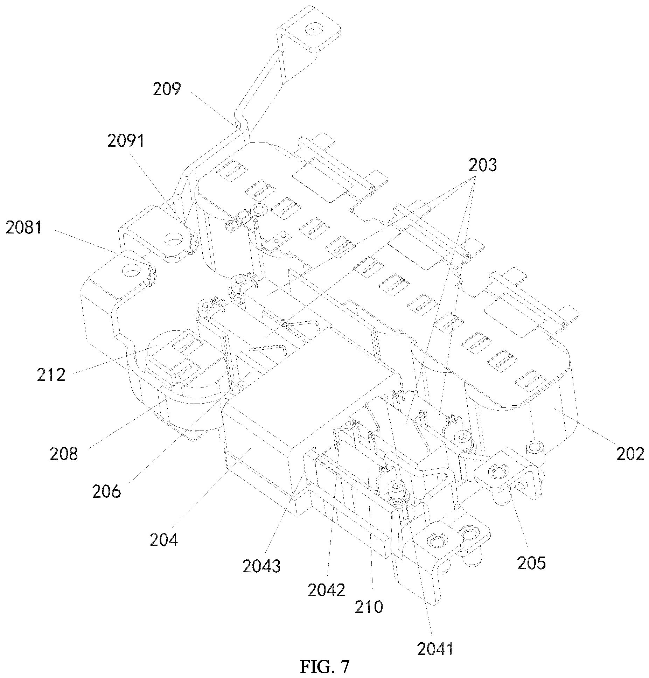

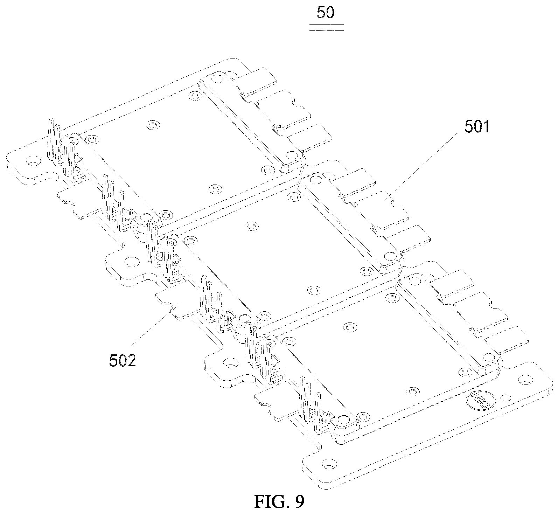

The motor controller of the disclosure will be described in detail below with reference to FIGS. 1 to 9.

As shown in FIGS. 1 to 5, the motor controller of the disclosure comprises a water-cooling plate 10, and a direct-current port module 20, an alternating-current port module 30 and an integrated circuit board 40 that are electrically connected to each other.

The direct-current port module 20 and the alternating-current port module 30 are both mounted on the water-cooling plate 10, the integrated circuit board 40 is mounted on the direct-current port module 20 and/or the alternating-current port module 30, the direct-current port module 20 and the alternating-current port module 30 are each integrated into one component, and the integrated circuit board 40 is a complete circuit board formed by integrating a control board and a drive board.

According to the disclosure, assembling steps of the motor controller can be greatly simplified by integrating the direct-current port module 20 into one component, integrating the alternating-current port module 30 into one component, and further integrating the control board and the drive board into one complete integrated circuit board 40. In addition, by integrating a plurality of components into one component, the size and the weight of the integrated component can also be effectively reduced.

Illustratively, the water-cooling plate 10 is located at the bottom, the integrated circuit board 40 is located at the top, the direct-current port module 20 and the alternating-current port module 30 are located between the water-cooling plate 10 and the integrated circuit board 40. During assembly, it is possible that the direct-current port module 20 and the alternating-current port module 30, which are integrated, are each first secured to the water-cooling plate 10 by means of screws, and the integrated circuit board 40 is then secured to the direct-current port module 20 and the alternating-current port module 30 by means of screws.

It should be noted that a control board and a drive board of a conventional motor controller are two independent circuit boards, and the two circuit boards are electrically connected by means of a high-voltage connection wiring harness. According to the disclosure, by integrating the control board and the drive board into one complete circuit board, that is, integrating all electrical components of a conventional control board and a conventional drive board onto one complete circuit board, one high-voltage connection wiring harness can be omitted, the area of the circuit board can also be reduced by about 10%, and accordingly the cost can be reduced by about 10%.

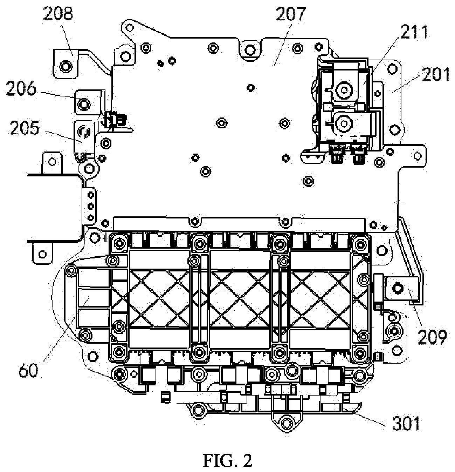

Preferably, as shown in FIGS. 2 to 6, the direct-current port module 20 of the disclosure comprises a first housing 201, and a large inverter capacitor 202, a filter capacitor 203, a magnetic filter core 204, a first input copper bar 205, a second input copper bar 206 and a shielding plate 207 that are integrated in the first housing 201.

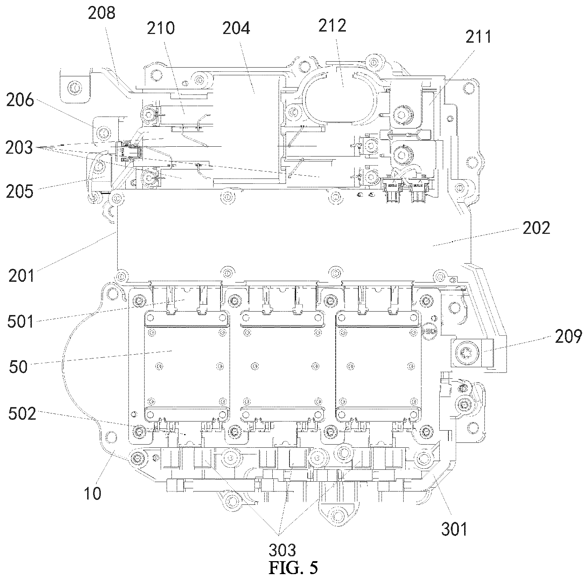

The first housing 201 is securely connected to the water-cooling plate 10, and a first end of the first input copper bar 205 (which is, viewed from FIG. 5, a left end of the first input copper bar 205) and a first end of the second input copper bar 206 (which is, viewed from FIG. 5, a left end of the second input copper bar 206) both extend out of the first housing 201 to be electrically connected to a positive electrode and a negative electrode of the battery pack respectively; and a second end of the first input copper bar 205 (which is, viewed from FIG. 5, a right end of the first input copper bar 205) and a second end of the second input copper bar 206 (which is, viewed from FIG. 5, a right end of the second input copper bar 206) respectively pass through a first penetration opening 2041 and a second penetration opening 2042 of the magnetic filter core 204 and are electrically connected to the large inverter capacitor 202, the large inverter capacitor 202 is electrically connected to the alternating-current port module 30, the shielding plate 207 is securely connected to the first housing 201 and located on a side of the first housing 201 away from the water-cooling plate 10, and the integrated circuit board 40 is securely connected to the shielding plate 207. The first housing 201 is preferably made of plastic.

Illustratively, the bottom of the first housing 201 is securely connected to the water-cooling plate 10 by means of screws, the shielding plate 207 is mounted on the top of the first housing 201, and the integrated circuit board 40 is secured on the shielding plate 207 by means of screws. The shielding plate 207 can cover high-power devices, such as the large inverter capacitor 202, the filter capacitor 203 and the magnetic filter core 204, in the first housing 201, preventing electromagnetic waves released during operation from affecting the low-power integrated circuit board 40.

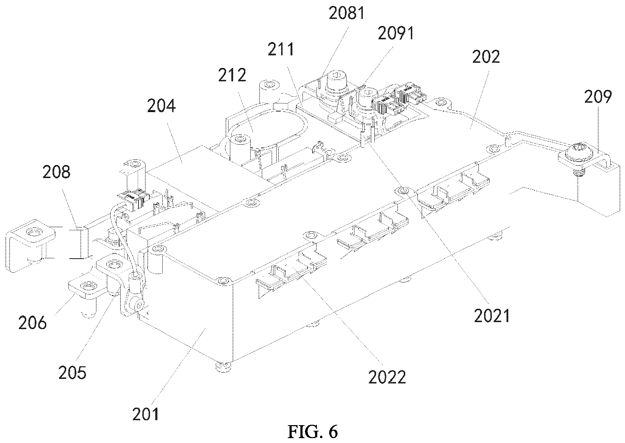

Preferably, as shown in FIGS. 1 and 6, the large inverter capacitor 202 is provided with a power-taking terminal 2021 thereon, and the power-taking terminal 2021 is electrically connected to the integrated circuit board 40.

Compared with a conventional design that a separate wiring harness is welded on a capacitor and is then connected to a circuit board by means of a plug-in connector, in the disclosure, the power-taking terminal 2021 is directly integrated on the large inverter capacitor 202, and the power-taking terminal 2021 is electrically connected to the integrated circuit board 40 to provide a high-voltage power supply for the integrated circuit board 40, such that the structure is more simplified and the connecting stability is better.

The power-taking terminal 2021 is welded and secured to the integrated circuit board 40 preferably by tin soldering.

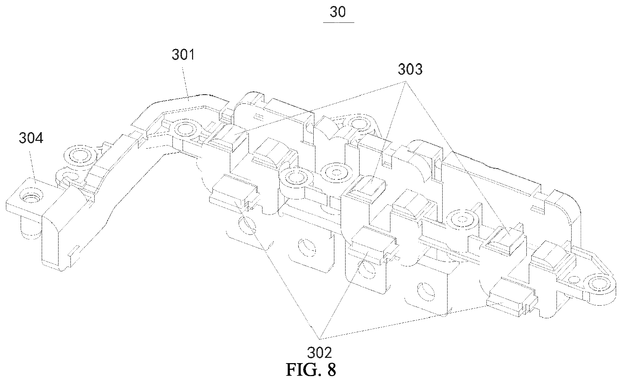

Preferably, as shown in FIG. 8, the alternating-current port module 30 of the disclosure comprises a second housing 301, and three alternating-current output copper bars 302 and three current sensors 303 that are integrated in the second housing 301.

First ends of the alternating-current output copper bars 302 extend out of the second housing 301 to be electrically connected to the large inverter capacitor 202, and the three current sensors 303 are respectively configured to detect the current of the corresponding alternating-current output copper bars 302. The second housing 301 is preferably made of plastic.

It should be noted that, as shown in FIG. 5, the motor controller of the disclosure further comprises, apart from the several components and parts described above, a conventional component of the motor controller, that is, a power module 50. The power module 50 is capable of converting direct current into alternating current, and the large inverter capacitor 202 of the direct-current port module 20 and the alternating-current output copper bars 302 of the alternating-current port module 30 are electrically connected by means of the power module 50.

Specifically, as shown in FIGS. 5 to 9, the power module 50 is located between the large inverter capacitor 202 and the alternating-current output copper bars 302, the large inverter capacitor 202 is provided with a plurality of first connection copper bars 2022 (for example, nine) on a side thereof close to the power module 50, the power module 50 is provided with a plurality of second connection copper bars 501 (for example, nine) on a side thereof close to the large inverter capacitor 202, and the first connection copper bars 2022 and the second connection copper bars 501 correspond to each other in a one-to-one manner and are welded together, preferably by means of laser welding.

The power module 50 is provided with three third connection copper bars 502 on the side thereof close to the alternating-current output copper bars 302, the third connection copper bars 502 and the alternating-current output copper bars 302 correspond to each other in a one-to-one manner and are welded together, also preferably by means of laser welding, and second ends of the alternating-current output copper bars 302 are connected to a three-phase copper bar of the electric motor. The alternating-current output copper bars 302 are capable of providing alternating sinusoidal current to the electric motor, ensuring that the electric motor rotates at a designated power in a designated direction, thereby propelling a vehicle to run.

The power module 50 is preferably a silicon carbide power module (also referred to as an SIC power module).

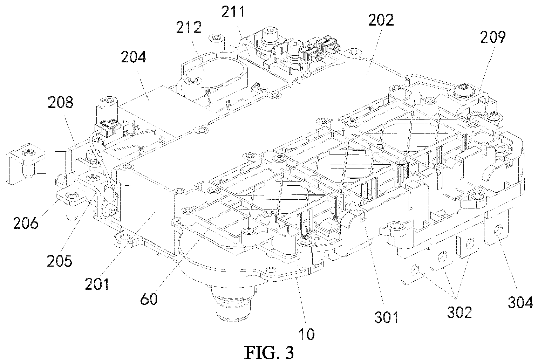

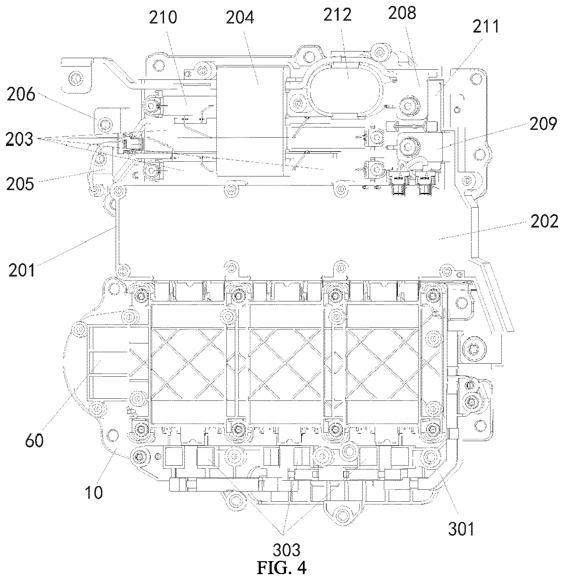

As shown in FIGS. 3 and 4, the power module 50 is sandwiched between a compressing cover 60 and the water-cooling plate 10, and the compressing cover 60 and the water-cooling plate 10 are securely connected by means of screws.

Preferably, as shown in FIGS. 3 to 8, the direct-current port module 20 of the disclosure further comprises a first central point copper bar 208, a second central point copper bar 209, a transformer filter capacitor 210, a relay 211 and a small relay capacitor 212 for protecting the relay 211, all of which are integrated in the first housing 201. The magnetic filter core 204 is formed by integrating two magnetic cores, the magnetic filter core 204 further comprises a third penetration opening 2043, and the alternating-current port module 30 further comprises a third central point copper bar 304 integrated in the second housing 301; the first end of the second input copper bar 206 is further used for electrical connection with a charging pile, a first end of the first central point copper bar 208 (which is, viewed from FIG. 5, a left end of the first central point copper bar 208) extends out of the first housing 201 to be electrically connected to the charging pile, and a second end of the first central point copper bar 208 (which is, viewed from FIG. 5, a right end of the first central point copper bar 208) passes through the third penetration opening 2043 and is electrically connected to the relay 211; and a first end of the second central point copper bar 209 is electrically connected to the relay 211, a second end of the second central point copper bar 209 is electrically connected to a first end of the third central point copper bar 304, and a second end of the third central point copper bar 304 extends out of the second housing 301 to be electrically connected to a central point of the electric motor.

The relay 211 is configured to control on/off states of the first central point copper bar 208 and the second central point copper bar 209. When it is not required to provide a charging circuit for the battery pack of the electric vehicle by means of a motor winding, the first central point copper bar 208 and the second central point copper bar 209 are in the off state; and when it is required to provide the charging circuit for the battery pack of the electric vehicle by means of the motor winding, the relay 211 connects the first central point copper bar 208 and the second central point copper bar 209, such that the central point of the electric motor is electrically connected to a positive electrode or a negative electrode of the charging pile by means of the three central point copper bars (the first central point copper bar 208, the second central point copper bar 209, and the third central point copper bar 304).

In some embodiments, a central point of a motor coil is connected to one end of a charging port of the charging pile by means of the three central copper bars, and is electrically connected to the other end of the charging port of the charging pile by means of the first input copper bar 205 or the second input copper bar 206, thereby allowing an inverter and the motor coil to implement a function of voltage conversion, for example, increasing the 400V voltage at the charging port of the charging pile to 800V and finally providing same to the battery pack of the electric vehicle.

By integrating the two magnetic cores into one magnetic filter core 204, the space, weight and cost of the disclosure can be saved greatly. In addition, a conventional relay has a larger space occupied for mounting and supporting. According to the disclosure, the relay 211 is integrated into the first housing 201 without increasing the space, so that the limited space is fully utilized.

According to the disclosure, by integrating the three alternating-current output copper bars 302, the three current sensors 303 and the third central point copper bar 304 into one component, the size is greatly reduced, an assembling process is simplified, and one component implements three functions.

It should be noted that, according to the disclosure, the small relay capacitor 212 is directly encapsulated into the first housing 201 preferably by means of an encapsulation adhesive, omitting a housing of the capacitor itself, thereby further reducing the size and weight of the motor controller.

Preferably, as shown in FIGS. 2 to 5, the first central point copper bar 208, the second input copper bar 206 and the first input copper bar 205 are arranged in sequence from an outer side to an inner side, and the first end of the first central point copper bar 208 is provided close to the first end of the second input copper bar 206.

By arranging the first central point copper bar 208 on the outermost side, the relay 211 and the small relay capacitor 212 are convenient to arrange. Moreover, after the voltage of the charging pile completely meets the requirements of the battery pack, that is, there is no need to increase the voltage for charging by means of the motor winding, such an arrangement also facilitates removing the first central point copper bar 208. Furthermore, by providing the first end of the first central point copper bar 208 to be close to the first end of the second input copper bar 206, the first central point copper bar 208 can share one external connector with the first input copper bar 205 and the second input copper bar 206, thereby further optimizing a layout.

Preferably, as shown in FIGS. 2 to 5, the third central point copper bar 304 and the second central point copper bar 209 are provided on the same side.

By providing the third central point copper bar 304 and the second central point copper bar 209 on the same side, path shortening of the central point copper bars is facilitated, the cost is saved, and energy loss is also reduced.

Illustratively, as shown in FIG. 3, the second input copper bar 206 is located between the first input copper bar 205 and the first central point copper bar 208; the first end of the first central point copper bar 208, the first end of the first input copper bar 205 and the first end of the second input copper bar 206 are all located on the left side of the motor controller; and the third central point copper bar 304 and the second central point copper bar 209 are both arranged on the right side of the motor controller.

Preferably, as shown in FIGS. 1, 6 and 7, the second end of the first central point copper bar 208 is provided with a first voltage sampling terminal 2081, the first end of the second central point copper bar 209 is provided with a second voltage sampling terminal 2091, and the first voltage sampling terminal 2081 and the second voltage sampling terminal 2091 are both electrically connected to the integrated circuit board 40.

The two voltage sampling terminals are used for voltage monitoring of the relay 211, so as to determine whether the relay 211 connects the first central point copper bar 208 and the second central point copper bar 209. Specifically, when there is a voltage difference between the first voltage sampling terminal 2081 and the second voltage sampling terminal 2091, it is indicated that the first central point copper bar 208 and the second central point copper bar 209 are not connected. On the contrary, when there is no voltage difference between the first voltage sampling terminal 2081 and the second voltage sampling terminal 2091, it is indicated that the first central point copper bar 208 and the second central point copper bar 209 are connected.

The first voltage sampling terminal 2081 and the second voltage sampling terminal 2091 are both welded to the integrated circuit board 40. The first voltage sampling terminal 2081 and the second voltage sampling terminal 2091 are connected to the integrated circuit board 40 preferably by means of tin soldering.

Preferably, as shown in FIG. 6, an end of the relay 211 close to the water-cooling plate 10 passes through the first housing 201 to be securely connected to the water-cooling plate 10.

Illustratively, the bottom end of the relay 211 passes through the bottom of the first housing 201 to be securely connected to the water-cooling plate 10 by means of screws.

It should be noted that those skilled in the art can understand that although some embodiments described herein comprise some but not other features comprised in other embodiments, combinations of features of different embodiments are meant to be within the scope of the disclosure and form different embodiments. For example, in the claims of the disclosure, any one of the claimed embodiments can be used in any combination.

Heretofore, the technical solutions of the disclosure have been described in combination with the preferred implementations shown in accompanying drawings. However, those skilled in the art can readily understand that the scope of protection of the disclosure is apparently not limited to these particular implementations. Those skilled in the art can make equivalent changes or substitutions to the related technical features without departing from the principle of the disclosure, and all the technical solutions with such changes or substitutions shall fall within the scope of protection of the disclosure.

## Claims

1. A motor controller, comprising a water-cooling plate, and a direct-current port module, an alternating-current port module and an integrated circuit board that are electrically connected to each other, the direct-current port module and the alternating-current port module being both mounted on the water-cooling plate, the integrated circuit board being mounted on the direct-current port module and/or the alternating-current port module, the direct-current port module and the alternating-current port module being each integrated into one component, and the integrated circuit board being a complete circuit board formed by integrating a control board and a drive board.

2. The motor controller according to claim 1, wherein the direct-current port module comprises a first housing, and a large inverter capacitor, a filter capacitor, a magnetic filter core, a first input copper bar, a second input copper bar and a shielding plate that are integrated in the first housing, wherein the first housing is securely connected to the water-cooling plate, a first end of the first input copper bar and a first end of the second input copper bar both extend out of the first housing to be electrically connected to a positive electrode and a negative electrode of a battery pack respectively, and a second end of the first input copper bar and a second end of the second input copper bar respectively pass through a first penetration opening and a second penetration opening of the magnetic filter core and are electrically connected to the large inverter capacitor; and the large inverter capacitor is electrically connected to the alternating-current port module, the shielding plate is securely connected to the first housing and located on a side of the first housing away from the water-cooling plate, and the integrated circuit board is securely connected to the shielding plate.

3. The motor controller according to claim 2, wherein the large inverter capacitor is provided with a power-taking terminal, and the power-taking terminal is electrically connected to the integrated circuit board.

4. The motor controller according to claim 2 or 3, wherein the alternating-current port module comprises a second housing, and three alternating-current output copper bars and three current sensors that are integrated in the second housing, wherein one side of the second housing is securely connected to the water-cooling plate, the other side of the second housing is securely connected to the integrated circuit board, first ends of the alternating-current output copper bars extend out of the second housing to be electrically connected to the large inverter capacitor, and the three current sensors are respectively configured to detect the current of the corresponding alternating-current output copper bars.

5. The motor controller according to claim 4, wherein the direct-current port module further comprises a first central point copper bar, a second central point copper bar, a transformer filter capacitor, a relay, and a small relay capacitor for protecting the relay that are integrated in the first housing, wherein the magnetic filter core is formed by integrating two magnetic cores, the magnetic filter core further comprises a third penetration opening, and the alternating-current port module further comprises a third central point copper bar integrated in the second housing; the first end of the second input copper bar is further used for electrical connection with a charging pile, a first end of the first central point copper bar extends out of the first housing to be electrically connected to the charging pile, and a second end of the first central point copper bar passes through the third penetration opening and is electrically connected to the relay; and a first end of the second central point copper bar is electrically connected to the relay, a second end of the second central point copper bar is electrically connected to a first end of the third central point copper bar, and a second end of the third central point copper bar extends out of the second housing to be electrically connected to a central point of an electric motor.

6. The motor controller according to claim 5, wherein the second end of the first central point copper bar is provided with a first voltage sampling terminal, the first end of the second central point copper bar is provided with a second voltage sampling terminal, and the first voltage sampling terminal and the second voltage sampling terminal are both electrically connected to the integrated circuit board.

7. The motor controller according to claim 5 or 6, wherein the first central point copper bar, the second input copper bar and the first input copper bar are arranged in sequence from an outer side to an inner side, and the first end of the first central point copper bar is provided close to the first end of the second input copper bar.

8. The motor controller according to any one of claims 5 to 7, wherein the third central point copper bar and the second central point copper bar are provided on the same side.

9. An electric motor, comprising a motor controller according to any one of claims 1 to 8.

10. A vehicle, comprising a motor controller according to any one of claims 1 to 8.
